(19) Europäisches Patentamt / European Patent Office / Office européen des brevets

(11) **EP 2 962 326 B1**

(12) **FASCICULE DE BREVET EUROPEEN**

(45) Date de publication et mention
de la délivrance du brevet:
**30.01.2019 Bulletin 2019/05**

(21) Numéro de dépôt: **14711828.5**

(22) Date de dépôt: **25.02.2014**

(51) Int Cl.:
*H01L 21/268* *(2006.01)*     *H01L 21/302* *(2006.01)*
*H01L 21/3065* *(2006.01)*     *H01L 21/20* *(2006.01)*

(86) Numéro de dépôt international:
**PCT/FR2014/050397**

(87) Numéro de publication internationale:
**WO 2014/131983 (04.09.2014 Gazette 2014/36)**

(54) **PROCEDE DE TRAITEMENT D'UNE STRUCTURE**

VERFAHREN ZUR BEHANDLUNG EINER STRUKTUR

PROCESS FOR TREATING A STRUCTURE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.02.2013 FR 1300439**

(43) Date de publication de la demande:
**06.01.2016 Bulletin 2016/01**

(73) Titulaire: **Soitec**
**38190 Bernin (FR)**

(72) Inventeur: **KONONCHUK, Oleg**
**F-38570 Theys (FR)**

(74) Mandataire: **IP Trust**
**2, rue de Clichy**
**75009 Paris (FR)**

(56) Documents cités:
**EP-A2- 2 485 249     US-A- 4 624 736
US-A1- 2009 121 157     US-B1- 6 830 993**

## Description

### DOMAINE DE L'INVENTION

La présente invention concerne un procédé de traitement d'une structure.

### ARRIERE PLAN DE L'INVENTION

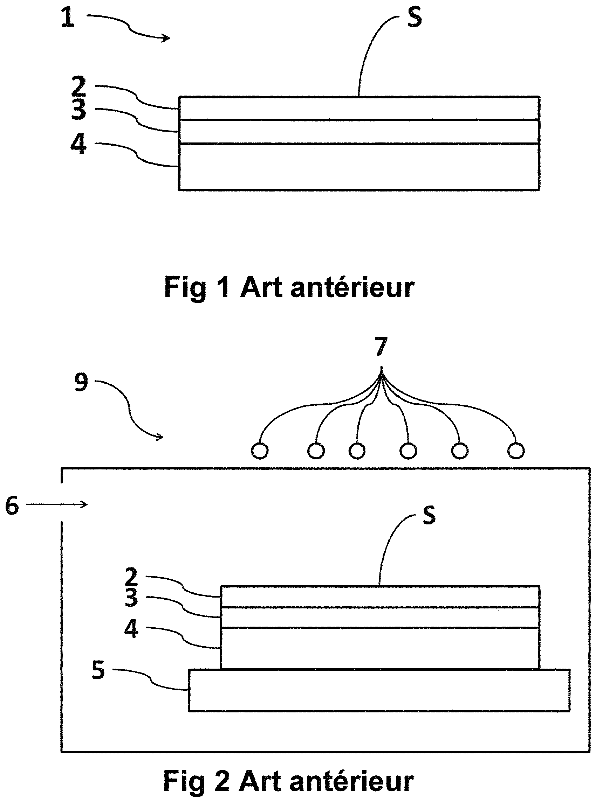

Une structure 1 comprend de sa face arrière vers sa face avant un substrat support 4, une couche d'isolant 3, et une couche utile 2, la couche utile 2 présentant une surface libre S. Dans un procédé de traitement d'une telle structure 1 connu de l'état de l'art, et illustré aux figures 1 et 2, la structure 1 est placée dans une atmosphère comprenant des espèces chimiques 6 sous forme gazeuse, les espèces chimiques 6 étant susceptibles de réagir chimiquement avec la couche utile 2 avec une cinétique strictement croissante en fonction de la température de la couche utile 2.

Pendant le procédé de traitement, la structure 1 est maintenue sur un support de structure 5 (ou « chuck » selon la terminologie anglo-saxonne). Le support de structure 5 est disposé dans une chambre de réaction 9.

La couche utile 2 est généralement chauffée de manière uniforme par l'intermédiaire d'un système de chauffage 7, par exemple des résistances chauffantes ou encore des lampes halogènes.

Ainsi, les espèces chimiques 6 injectées dans la chambre de réaction 9 réagissent chimiquement avec la surface libre S de la couche utile 2. Le type de réaction chimique dépend de la nature des espèces chimiques 6 et de la couche utile 2, et peut alors prendre la forme d'un amincissement par une gravure de la couche utile 2, ou encore d'un épaississement par épitaxie de la couche utile 2.

Cependant, la couche utile 2 présente généralement des variations d'épaisseurs et les procédés de gravure ou d'épaississement par épitaxie sont connus pour être non uniformes, dégradant encore un peu plus les variations d'épaisseur de la couche utile 2. Par conséquent, des variations d'épaisseurs de la couche utile 2 subsistent après le procédé de traitement.

Donc, le principal inconvénient de ce procédé de traitement est que, lors de la réaction d'amincissement ou d'épaississement, les variations d'épaisseurs de la couche utile 2 subsistent et peuvent même être dégradées.

Ainsi, les structures 1, telles que des structures du type semi-conducteur sur isolant (SeOI), présentent des variations d'épaisseurs dont l'analyse spectrale révèle des composantes de longueurs d'ondes spatiales variant de quelques nanomètres (assimilable à de la rugosité) à la taille de la structure 1 (assimilable à de la non uniformité). Certaines techniques (des recuits de lissage sous atmosphère réductrice par exemple) permettent de réduire les variations d'épaisseur de longueur d'onde spatiale inférieures à un certain seuil, par exemple 2 $\mu$m. Cependant, sur la gamme des longueurs d'onde spatiales au delà de ce seuil, par exemple comprises entre 2 $\mu$m et quelques centimètres, la réduction des non uniformités en épaisseur de la couche utile 2 reste très difficile.

Notamment, un procédé d'épaississement par épitaxie de la couche de semi-conducteur, ou d'amincissement par gravure de la couche de semi-conducteur, d'une structure 1 de type SeOI, ne réduit pas notablement les variations d'épaisseurs de la couche de semi-conducteur sur une gamme de longueur d'onde étendue.

Par ailleurs, on connaît du document US20090121157 un dispositif et une méthode utilisés pour recuire des régions choisis d'un substrat. Des impulsions d'énergie électromagnétique sont délivrés au substrat par l'intermédiaire d'une lampe flash ou d'un laser.

L'invention propose un procédé de traitement d'une structure 1 visant à réduire les variations d'épaisseur de la couche utile 2.

### BREVE DESCRIPTION DE L'INVENTION

La présente invention vise à remédier en tout ou partie à l'inconvénient précité, et concerne un procédé de traitement d'une structure, la structure comprenant de sa face arrière vers sa face avant un substrat support, une couche d'isolant, et une couche utile, la couche utile présentant une surface libre, la structure étant placée dans une atmosphère comprenant des espèces chimiques sous forme gazeuse, les espèces chimiques étant susceptibles de réagir chimiquement avec la couche utile, avec une cinétique strictement croissante en fonction de la température de la couche utile; ledit procédé de traitement étant remarquable en ce que la couche utile est chauffée par un faisceau laser à impulsions, le faisceau balayant au moins en partie la surface libre de la couche utile, la longueur d'onde du faisceau étant différente de moins de 15 nm, de préférence de moins de 7 nm, d'une longueur d'onde centrale pour laquelle la dérivée partielle de la réflectivité de la structure par rapport à l'épaisseur de la couche d'isolant est nulle.

Les impulsions laser permettent de générer un échauffement au point d'impact desdites impulsions sur la surface libre de la couche utile.

La température ainsi atteinte par la couche utile audit point d'impact permet d'activer la réaction chimique des espèces chimiques avec la couche utile. Cette température est inférieure à la température de fusion du matériau de la couche utile.

Pour une longueur d'onde du faisceau différente de moins de 15 nm, de préférence de moins de 7 nm, de la longueur d'onde centrale, la Déposante a constaté que l'échauffement de la couche utile ne dépend que de l'épaisseur de cette couche.

Dit autrement, l'échauffement de la couche utile, au cours du balayage par le faisceau laser, est essentiellement indépendant des faibles variations d'épaisseur de la couche d'isolant. Par faibles variations de l'épaisseur de la couche d'isolant, on entend des variations d'épaisseur de plus ou moins 1nm.

La longueur d'onde des impulsions laser peut être choisie de sorte à chauffer les zones de la couche utile les plus épaisses à une température plus importante que les zones les moins épaisses.

Ainsi, une réaction d'amincissement par gravure, activée par les impulsions laser, présentera une cinétique plus importante dans les zones les plus épaisses de la couche utile.

De la même manière, la longueur d'onde des impulsions laser peut être choisie de sorte à chauffer les zones de la couche utile les moins épaisses à une température plus importante que les zones les plus épaisses.

Ainsi, une réaction d'épaississement par épitaxie présentera une cinétique plus importante dans les zones les plus fines de la couche utile.

Le contrôle, suivant l'épaisseur, de l'échauffement de la couche utile et donc de la cinétique de réaction d'épaississement ou d'amincissement permet ainsi de réduire les variations d'épaisseurs de la couche utile.

Selon un mode de mise en oeuvre, la structure est disposée dans une enceinte réactive comprenant les espèces chimiques.

Selon un mode de mise en oeuvre, la durée des impulsions du faisceau laser sont inférieure à une valeur tv, tv étant égal à : $t_v = l^2/D$, D étant le coefficient de diffusion thermique dans la couche utile, et l correspondant à une longueur d'onde seuil au delà de laquelle on souhaite réduire les variations d'épaisseur de la couche.

On entend par la durée d'une impulsion laser, un temps unitaire durant lequel un faisceau est émis.

Pour des durées d'impulsions inférieures à tv, il est possible de ne pas atteindre l'équilibre thermique sur toute la surface du point d'impact des impulsions laser sur la couche utile. Ceci est particulièrement intéressant lorsque des variations d'épaisseurs de la couche utile de longueur d'onde spatiale inférieure à la dimension du point d'impact des impulsions laser doivent être corrigées. En effet, pour de telles durées d'impulsions, le point d'impact ne subit pas un échauffement uniforme sur toute sa surface, plus précisément les zones du point d'impact les plus fines ne sont pas chauffées à la même température que les zones du point d'impact les plus épaisses.

Selon un mode de mise en oeuvre, le faisceau laser à impulsions a une durée d'impulsion inférieure à 100 ns.

Selon un mode de mise en oeuvre, la couche utile est une couche de matériau semi-conducteur comprenant au moins un des matériaux suivant : Silicium, Germanium, Alliage de silicium Germanium.

Selon un mode de mise en oeuvre, les espèces chimiques permettent de graver la couche utile et la longueur d'onde du faisceau laser à impulsions est choisie de sorte à correspondre à une valeur négative de la sensibilité de la réflectivité de la structure par rapport à la couche utile.

Ainsi, plus la zone de la couche utile impactée par les impulsions laser est épaisse plus la température atteinte lors de l'échauffement est importante. Par conséquent, plus la zone de la couche utile est épaisse, plus la cinétique de gravure est importante. Il est donc possible d'effectuer une gravure partielle de la couche utile sur toute sa surface tout en réduisant la variation d'épaisseur de la couche utile.

Selon un mode de mise en oeuvre, les espèces chimiques comprennent du HCl.

Ainsi, il est possible de graver une couche utile comprenant des éléments semi-conducteurs tels que du Silicium, du Germanium, ou encore des alliages de Silicium Germanium.

Selon un mode de mise en oeuvre, les espèces chimiques permettent d'épaissir la couche utile par épitaxie, et la longueur d'onde du faisceau laser à impulsions est choisie de sorte à correspondre à une valeur positive de la sensibilité de la réflectivité de la structure par rapport à la couche utile.

Ainsi, plus la zone de la couche utile impactée par les impulsions laser est fine, plus la température atteinte lors de l'échauffement est importante.

Par conséquent, plus la zone de la couche utile est fine, plus la cinétique d'épaississement par épitaxie est importante. Il est donc possible d'effectuer un épaississement par épitaxie de la couche utile sur toute sa surface tout en réduisant la variation d'épaisseur de la couche utile.

Selon un mode de mise en oeuvre, les espèces chimiques comprennent au moins une des espèces suivante : Silane, di-silane, tri-silane, mono-chlorosilane, di-chlorosilane, tri-chlorosilane, tétra-chlorosilane, germane, mono-chlorogermane, di-chlorogermane, tri-chlorogermane, tétrachlorogermane.

Selon un mode de mise en oeuvre, la couche d'isolant comprend du dioxyde de silicium.

Selon un mode de mise en oeuvre, la couche d'isolant présente une épaisseur inférieure à 150 nm, de préférence inférieure à 50 nm, encore plus préférentiellement inférieure à 25 nm.

Selon un mode de mise en oeuvre, la couche utile présente une épaisseur inférieure à 50 nm, préférentiellement inférieure à 25 nm.

Selon un mode de mise en oeuvre, la surface du point d'impact du faisceau laser sur la surface libre de la couche utile est supérieure à 0.1 mm$^2$, de préférence supérieure à 10 mm$^2$.

Selon un mode de mise en oeuvre, le faisceau laser à impulsions a une énergie d'impulsion comprise entre 100 et 1500 mJ/cm$^2$, cette gamme d'énergie permettant d'obtenir un échauffement de la couche utile compatible avec une réaction chimique des espèces avec la couche utile.

Selon un mode de mise en oeuvre, le faisceau laser à impulsions a une fréquence de répétition des impulsions comprise entre 1 Hz, et 10 kHz.

Selon un mode de mise en oeuvre, la couche utile présente une variation d'épaisseur inférieure à 3 nm, de préférence inférieure à 2 nm, encore plus préférentiellement inférieure à 1 nm.

**BREVE DESCRIPTION DES DESSINS**

D'autres caractéristiques et avantages apparaîtront dans la description qui va suivre de deux modes de mise en oeuvre d'un procédé de traitement d'une structure selon l'invention, donnés à titre d'exemples non limitatifs, en référence aux dessins annexés dans lesquels :

- la figure 1 est une vue en coupe d'une structure traité par un procédé de traitement selon les techniques connues de l'art antérieur,
- la figure 2 illustre de manière schématique une enceinte de réaction permettant de traiter une structure selon les techniques connues de l'art antérieur,
- la figure 3 est une vue en coupe d'une structure traitée par un procédé de traitement selon l'invention,
- la figure 4 illustre de manière schématique une enceinte de réaction permettant de traiter une structure selon l'invention,
- la figure 5 illustre de manière schématique les réflexions se produisant dans deux couches d'une structure,
- la figure 6 présente les courbes de sensibilité de la réflectivité estimée d'une pluralité de structures de silicium sur isolant, en fonction de la longueur d'onde, par rapport à la couche mince de silicium (courbes Si1 et Si2) et par rapport à la couche d'oxyde enterrée (courbes BOX1 et BOX2),
- la figure 7 présente les élévations de température respectivement générées par un laser à impulsions sur une structure de silicium sur isolant comprenant une couche d'oxyde de silicium enterrée de 25 nm, une couche de silicium de 12 nm, et de respectivement 13 nm dans une autre zone de la structure,
- La figure 8 est un schéma de principe du chauffage d'une zone de la couche utile présentant une variation d'épaisseur à une échelle de distances inférieure à la taille du faisceau laser à impulsions.
- La figure 9 illustre le mode de chauffage B selon lequel l'intensité du rayonnement réfléchi diminue lorsque l'épaisseur de la couche utile augmente.

**DESCRIPTION DETAILLEE DE MODES DE REALISATION DE L'INVENTION**

Pour les différents modes de mise en oeuvre, les mêmes références seront utilisées pour des éléments identiques ou assurant la même fonction, par souci de simplification de la description.

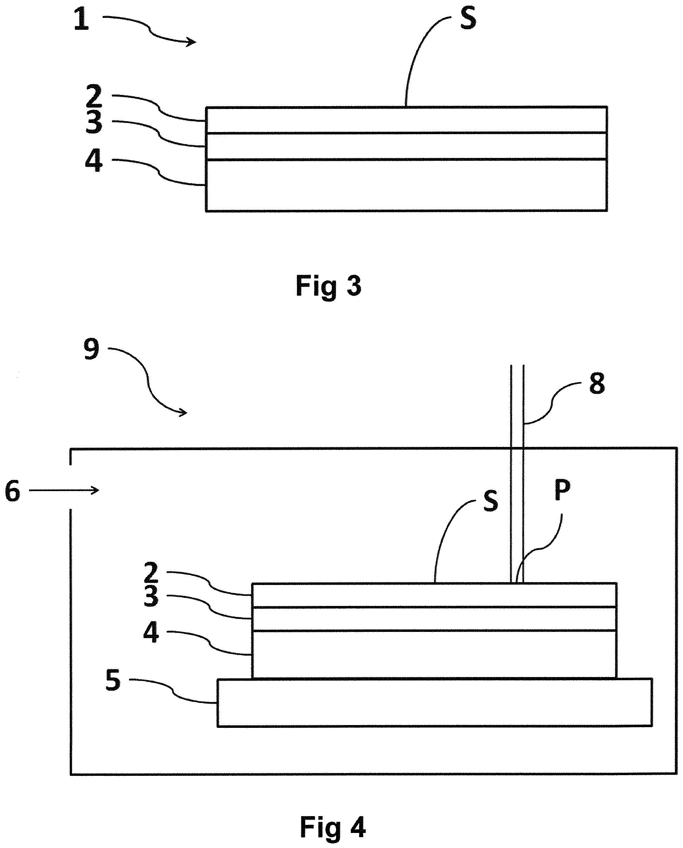

Selon le procédé de traitement illustré aux figures 3 et 4, la structure 1, comprenant de sa face arrière vers sa face avant une substrat support 4, une couche d'isolant 3, et une couche utile 2 présentant une surface libre S, est placée dans une atmosphère comprenant des espèces chimiques 6 sous forme gazeuse susceptibles de réagir chimiquement avec la couche utile 2 avec une cinétique strictement croissante en fonction de la température de la couche utile 2. La couche utile 2 est chauffée par un faisceau 8 laser à impulsions, le faisceau 8 balayant au moins en partie la surface libre S de la couche utile 2.

L'échauffement obtenu dans une structure multicouche complexe, telle que la structure 1, est dépendant de la manière avec laquelle le rayonnement du faisceau laser est réfléchi sur les différentes interfaces de la structure. De manière bien connue, cette réflectivité est une fonction de la nature et des épaisseurs des couches, de la polarisation du laser, de son angle d'incidence, et de sa longueur d'onde. Pour une structure donnée et des conditions d'application du laser donné, c'est à dire lorsque la nature des couches, la polarisation, l'angle d'incidence et la longueur d'onde du laser sont fixés, l'échauffement de la couche utile 2 obtenu en deux points distincts d'application du laser différera suivant les écarts d'épaisseur de chacune des couches 2 et 3 entre ces deux points. En conséquence, et toute choses étant égales par ailleurs, le profil d'échauffement de la surface libre de la couche utile 2 reflète les non uniformités d'épaisseur de la couche utile 2 et de la couche d'isolant 3.

L'invention cherche à placer la structure dans des conditions de traitement telles que le profil d'échauffement de la surface libre de la couche utile 2 obtenu lors du balayage par le laser, soit uniquement dépendant des variations d'épaisseur de cette couche utile 2 et insensible à aux variations d'épaisseur de la couche d'isolant 3.

Pour ce faire la longueur d'onde du faisceau 8 laser est choisi à moins de 15 nm, de préférence à moins de 7 nm, d'une longueur d'onde centrale, pour laquelle la sensibilité de la réflectivité estimée de la structure 1 par rapport à la couche d'isolant 3 est nulle.

La valeur de cette longueur d'onde centrale est déterminée par le calcul, sur la base d'un modèle de réflectivité de la structure 1; c'est à dire d'un modèle mathématique d'une structure présentant les caractéristiques nominales de la structure 1. La longueur d'onde du laser est choisie, dans la gamme précitée, selon la disponibilité de laser présentant une longueur d'onde de faisceau proche de la longueur d'onde centrale.

L'invention tire profit des conditions de traitement ainsi déterminées, pour réduire les variations d'épaisseur de la couche utile 2.

L'utilisation d'un faisceau 8 laser à impulsions, plutôt qu'un laser continu, permet de circonscrire l'échauffement au niveau du point d'impact P (illustré sur la figure 4) du faisceau 8 sur la couche utile 2 et son volume sous-jacent. Un faisceau laser à impulsions balayant la surface libre S de la couche utile 2 chauffe de manière individuelle les différents points d'impacts de la couche utile 2. Et selon l'invention, l'échauffement sur chaque point d'impact de la couche utile 2 dépend de l'épaisseur de couche utile 2 audit point d'impact P et de la durée de l'impulsion laser.

L'invention est notablement applicable à des structures du type silicium sur isolant. La couche d'isolant 3 peut comprendre alors du dioxyde de silicium. La couche d'isolant 3 peut présenter une épaisseur inférieure à 150 nm, de préférence inférieure à 50 nm, encore plus préférentiellement inférieure à 25 nm. La couche utile 2 de silicium peut présenter une épaisseur inférieure à 50 nm, préférentiellement inférieur à 25 nm. De manière avantageuse, la couche utile 2 peut présenter avant traitement, une variation d'épaisseur inférieure à 3 nm, de préférence inférieure à 2 nm, encore plus préférentiellement inférieure à 1 nm.

## Détermination de la réflectivité estimée d'une structure

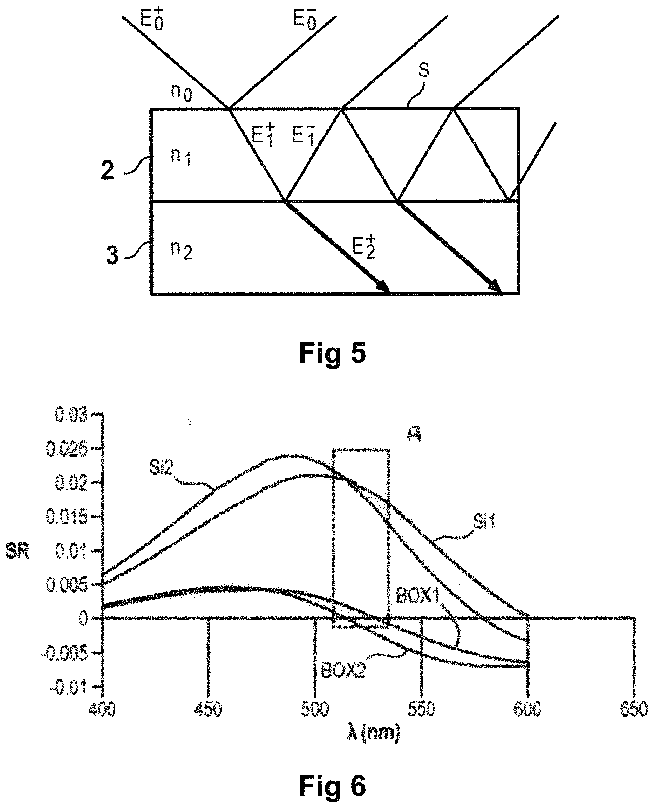

La figure 5 illustre de manière schématique les réflexions se produisant dans la couche utile 2 et la couche d'isolant 3 d'une structure 1 (le substrat support 4 n'a pas été représenté).

Un rayon $E^+_0$ incident sur la surface libre S est partiellement réfléchi sur ladite surface et partiellement transmis à travers la couche utile 2.

La partie du rayon transmis est à son tour partiellement réfléchie à l'interface entre la couche utile 2 et la couche d'isolant 3, et partiellement transmise à travers la couche d'isolant 3. Et ces réflexions/transmissions sont répétées à chacune des interfaces de la structure, l'énergie réfléchie $E^-_0$ résulte donc de ces interactions complexes.

La réflectivité d'une structure correspond au rapport entre l'énergie réfléchie $E^-_0$ et l'énergie incidente $E^+_0$

Comme cela est bien connu en soit, la réflectivité d'un empilement comme celui formé par la structure 1 est déterminée par application des équations de Fresnel, et dépend de plusieurs paramètres dont notamment l'épaisseur de chacune des couches, la polarisation du flux lumineux incident, l'angle d'incidence et la longueur d'onde du flux lumineux. On pourra à ce titre se référer à l'annexe C de l'ouvrage « Spectroscopic Ellipsometry and reflectometry, a user guide" de H.G. Tompkins et W.A McGahan, édité par Wiley interscience publication, 1999.

De manière opérationnelle, pour des paramètres nominaux d'une structure et d'un flux lumineux, la réflectivité est déterminée par l'intermédiaire de logiciels de simulation numérique largement disponible. On connaît ainsi le logiciel dénommé IMD, disponible en téléchargement à http://www.rxollc.com/idl/; et décrit dans la publication « IMD - Software for modeling the optical properties of multilayer films », D.L Windt, COMPUTER IN PHYSISCS, VOL12, N°4, JUL/AUG 1998.

Le modèle établi par ces logiciels permet d'obtenir une réflectivité estimée d'une structure réelle.

Par simulation, on peut donc représenter sous forme de table numérique ou graphiquement la réflectivité estimée d'une structure pour une série de valeurs de la longueur d'onde du rayon incident, les autres paramètres du modèle étant fixés à leurs valeurs nominales.

## Détermination de la sensibilité de la réflectivité estimée

La sensibilité de la réflectivité estimée de la structure 1 par rapport à la couche d'isolant 3 (respectivement la couche utile 2) correspond à la dérivée partielle de la réflectivité par rapport à l'épaisseur de la couche d'isolant 3 (respectivement la couche utile 2).

Pratiquement, cette étape de dérivation est réalisée par des algorithmes de dérivation numérique, bien connus en soi, comme par exemple la méthode du quotient différentiel. Ces algorithmes peuvent faire parti des outils proposés dans les logiciels de simulation numérique permettant de déterminer la réflectivité de la structure, ou peuvent être disponible dans des logiciels indépendant.

Par exemple, on peut calculer sur la base du modèle établi la sensibilité de la réflectivité estimée de la structure 1 par rapport à la couche utile 2 en prenant la différence entre la réflectivité estimée de la structure 1 pour deux épaisseurs différentes de la couche utile 2, la différence entre ces deux épaisseurs étant par exemple de 0,1 nm, les autres paramètres du modèle restant fixés à leurs valeurs nominales.

Similairement, pour la même structure 1, on calcul sur la base du modèle établi la sensibilité de la réflectivité de la structure 1 par rapport à la couche d'isolant 3 en prenant la différence entre la réflectivité estimée de la structure 1 pour deux épaisseurs différentes de la couche d'isolant 3, la différence entre ces deux épaisseurs étant par exemple de 0,1 nm.

Ainsi, la figure 6 représente graphiquement la sensibilité de la réflectivité estimée (notée SR, exprimée en $A^{-1}$) d'une pluralités de structures 1 de silicium sur dioxyde de silicium en fonction de la longueur d'onde À avec une lumière non polarisée calculées d'incidence normale.

Sur cette figure 6, la courbe Si1 représente, en fonction de la longueur d'onde du laser, la sensibilité de la réflectivité estimée par rapport à la couche utile dans le cas d'une structure présentant une épaisseur nominale de la couche utile 2 de silicium de 12nm et une épaisseur nominale de la couche d'isolant 3 en oxyde de silicium de 25nm.

La courbe Si2 représente, en fonction de la longueur d'onde du laser, la sensibilité de la réflectivité estimée par rapport à la couche utile dans le cas d'une structure présentant une épaisseur nominale de la couche utile 2 de silicium de 13nm et une épaisseur nominale de la couche d'isolant 3 en oxyde de silicium de 25nm.

La courbe BOX1 représente, en fonction de la longueur d'onde du laser, la sensibilité de la réflectivité estimée par rapport à la couche d'isolant dans le cas d'une structure présentant une épaisseur nominale de la couche utile 2 de silicium de 12nm et une épaisseur nominale de la couche d'isolant 3 en oxyde de silicium de 25nm.

La courbe BOX2 représente, en fonction de la longueur d'onde du laser, la sensibilité de la réflectivité estimée par rapport à la couche d'isolant dans le cas d'une structure présentant une épaisseur nominale de la couche utile 2 de silicium de 12nm et une épaisseur nominale de la couche d'isolant 3 en oxyde de silicium de 26nm.

**Choix de la longueur d'onde du faisceau laser à impulsions**

La longueur d'onde du laser à impulsion centrale est la longueur d'onde, notée $\lambda_0$, annulant la sensibilité de la réflectivité estimée d'une structure 1 par rapport à la couche d'isolant 3

Pour des longueurs d'ondes du laser à impulsion proche de la longueur centrale $\lambda_0$, la déposante a confirmé qu'il se produit un échauffement de la couche utile 2 essentiellement indépendant des variations d'épaisseurs de la couche d'isolant 3

Par longueurs d'ondes proches de la longueur d'onde centrale, on entend des longueurs d'ondes comprises entre $\lambda_0$-15 nm et $\lambda_0$+15 nm, encore plus préférentiellement entre $\lambda_0$-7 nm et $\lambda_0$+7 nm.

Dans certains cas, la longueur d'onde du laser à impulsions peut être sélectionnée de sorte à ce que plus la couche utile 2 est fine, plus la température atteinte par la couche utile 2 est importante. Ce résultat est obtenu lorsque la sensibilité de la réflectivité estimée de la structure 1 donnée par rapport à la couche utile 2 est positive. Ces 2 conditions portant sur la longueur d'onde du flux lumineux sont notées mode de chauffage A, représenté sur la figure 6.

Selon le mode de chauffage A, l'intensité du rayonnement réfléchi augmente lorsque l'épaisseur de la couche utile augmente. Par conséquent, l'échauffement est moins important lorsque l'épaisseur de la couche utile 2 augmente. De plus, la sensibilité de la réflectivité estimée par rapport à la couche d'isolant 3 étant proche de 0, l'échauffement est essentiellement indépendant des variations d'épaisseur de la couche d'isolant.

Dans d'autres cas, la longueur d'onde du laser à impulsions peut être sélectionnée de sorte à ce que plus la couche utile 2 est épaisse, plus la température atteinte par la couche utile 2 est importante. Ce résultat est obtenu lorsque la sensibilité de la réflectivité estimée de la structure 1 donnée par rapport à la couche utile 2 est négative.

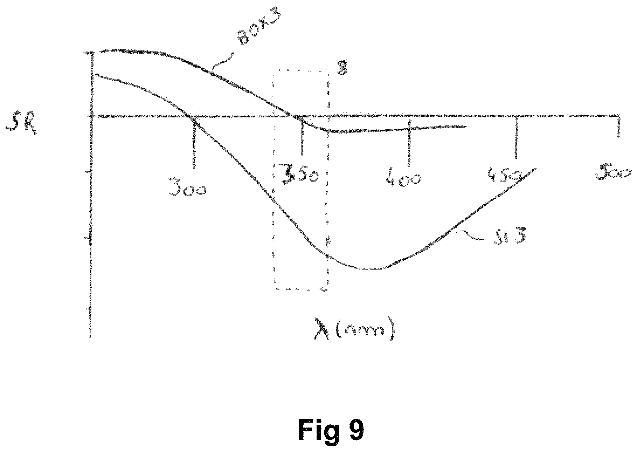

Ces 2 conditions portant sur la longueur d'onde du flux lumineux sont notées mode de chauffage B, et sont illustrés sur la figure 9, sur laquelle courbe BOX3 représente, en fonction de la longueur d'onde du laser, la sensibilité de la réflectivité estimée d'une structure par rapport à la couche d'isolant ; et la courbe Si3 représente, en fonction de la longueur d'onde du laser, la sensibilité de la réflectivité estimée de cette structure par rapport à la couche utile.

Selon le mode de chauffage B, l'intensité du rayonnement réfléchi diminue lorsque l'épaisseur de la couche utile augmente. Par conséquent, l'échauffement est plus important lorsque l'épaisseur de la couche utile 2 augmente. De plus, la sensibilité de la réflectivité estimée par rapport à la couche d'isolant 3 étant proche de 0, l'échauffement est essentiellement indépendant des variations d'épaisseur de la couche d'isolant.

On note que $\lambda_0$ est déterminé sur la base d'un modèle présentant les paramètres d'épaisseur nominaux de la structure 1. Lors du traitement selon l'invention d'une structure réelle, cette structure peut présenter des paramètres, et notamment des épaisseurs, déviant du modèle. C'est en particulier le cas lorsque le traitement comprend un épaississement ou un amincissement de la couche utile 2 de la structure. Ces déviations, si elles restent raisonnable (de l'ordre de 1nm), ne remettent pas en cause la validité du modèle, c'est à dire la faculté de chauffer sélectivement une couche utile 2 uniquement en fonction de sa variation d'épaisseur. Cela est par exemple remarquable sur la figure 6 en observant que les courbes BOX1 et BOX2, respectivement Si1 et Si2, de sensibilité de réflectivité estimée de structures restent similaires malgré une variation de l'épaisseur de la couche isolante 3, respectivement de la couche utile 2, de 1nm.

A titre d'illustration, considérons une structure 1 de silicium sur isolant comprenant une couche de dioxyde de silicium de 25nm d'épaisseur nominale, et une couche de silicium de 12nm d'épaisseur nominale.

Selon la figure 6 (courbe BOX1), l'énergie d'un faisceau 8 laser de longueur d'onde égale à 510 nm correspond à un mode de chauffage A.

La structure 1 est alors irradiée par un laser à impulsions présentant les caractéristiques suivantes :

- une longueur d'onde de 510 nm ;
- des impulsions de 10 ns ;
- fréquence de répétition des impulsions de 10 kHz ;
- énergie des impulsions 500 mJ/cm$^2$;

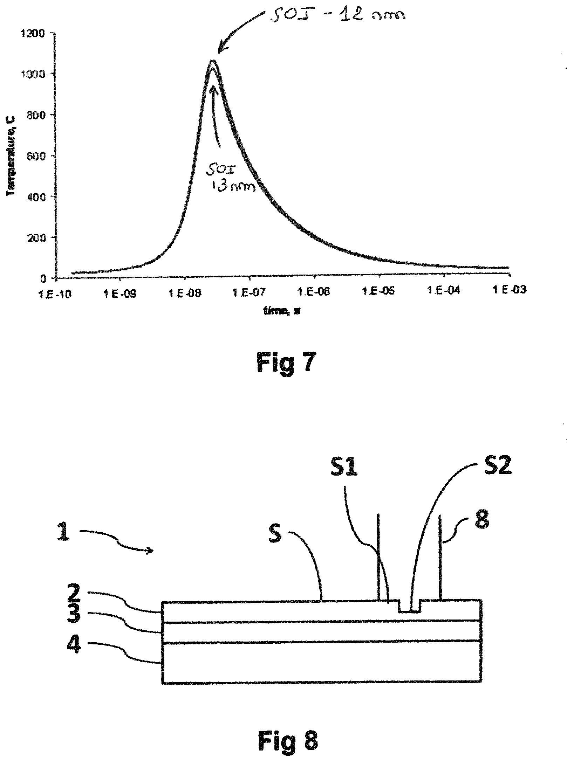

Telle que représentée à la figure 7, la température atteinte par la couche de silicium est de 1000°C pour une couche de 12 nm (c'est à dire correspondant à l'épaisseur nominale de la structure 1), tandis qu'elle n'est que de 950°C pour une couche de 13 nm (c'est à dire déviant de 1 nm de l'épaisseur nominale de la structure 1).

Les zones les plus fines de la couche de silicium sont chauffées à des températures plus importantes que les zones les plus épaisses.

**Détermination de la durée de l'impulsion laser.**

L'échauffement de la couche utile 2 généré par le laser à impulsion, diffuse sur une distance d selon la loi :

$$d = \sqrt{(Dt)}$$

où t est la durée d'une impulsion laser, D le coefficient de diffusion thermique du matériau composant la couche utile, et d la distance parcourue par le front de diffusion de chaleur.

Cet effet de diffusion, s'il n'est pas contrôlé, ne permet donc pas de chauffer sélectivement des zones proches, par exemple des zones contenues dans le point d'impact du faisceau laser.

Lorsque l'on souhaite néanmoins corriger des non-uniformités d'épaisseur de longueurs d'onde relativement petite, notamment inférieure à la dimension du point d'impact du faisceau, il est nécessaire de contrôler la diffusion de la chaleur. Ceci est obtenu en choisissant la durée t d'une impulsion du laser.

Plus précisément, s'il on souhaite corriger des variations d'épaisseur de la couche utile dans ses composantes spectrales de longueur d'onde supérieure à un seuil l (l pouvant être inférieur à la dimension du faisceau), on sélectionne une durée d'impulsion laser inférieure à $t_v$, où $t_v$ est définie par la loi suivante :

$$t_v = \frac{l^2}{D}$$

Ainsi, pour des durées d'impulsions t inférieures à tv, il est possible de ne pas atteindre l'équilibre thermique sur toute la surface du point d'impact des impulsions laser sur la couche utile 2, et le point d'impact ne subit pas un échauffement uniforme sur toute sa surface.

Plus précisément, les zones les plus fines du point d'impact ne sont pas chauffées à la même température que les zones les plus épaisses du point d'impact.

A titre d'exemple d'application, considérons le cas de structure 1 SOI (silicium sur isolant) présentant des trous non traversant. Ces trous contribuent aux variations d'épaisseur de la couche utiles 2, et ces variations peuvent être modélisées par exemple sous la forme d'une onde spatiale de longueur d'onde de 1 micromètre.

Par trous non traversant, on entend des trous qui ne s'étendent pas sur toute l'épaisseur de la couche utile 2.

Le coefficient de diffusion thermique du silicium est égal à 87 micromètre$^2$/s. tv est alors égale à 11.5 ns, en application de la formule précédente en prenant pour valeur seuil l = 1 micromètre.

Telle qu'illustrée à la figure 8, une structure 1 présente une région S1 plus épaisse qu'une région S2 qui forme donc un trou non traversant. Les régions S1 et S2 sont irradiées par un faisceau 8 laser à impulsions, dont le point d'impact présente une dimension de plusieurs mm$^2$, donc bien supérieure à la dimension de S2. La longueur d'onde du laser correspondant aux conditions de mode de chauffage A, et la durée de l'impulsion est choisie égale à 10ns, donc inférieure à tv.

L'équilibre thermique sur toute la surface du point d'impact n'étant pas atteint pour des impulsions d'une durée inférieure à tv, il est alors possible d'observer un échauffement plus important dans la zone S2 que dans la zone S1. Cet échauffement sélectif permet la réduction de la variation d'épaisseur lors de l'épaississement de la couche utile 2. Pour des conditions selon un mode de chauffage B, l'effet inverse sera observé et on appliquera donc une correction d'épaisseur par gravure de la couche utile 2.

De manière particulièrement avantageuse, les modes de chauffage A et B sont réalisés avec un laser à impulsions présentant au moins une des caractéristiques suivantes :

- Le point d'impact P du faisceau 8 laser à impulsions peut avoir une surface supérieure à 0.1 mm$^2$, de préférence supérieure à 10 mm$^2$.
- une durée d'impulsion inférieure à 100 ns, de préférence inférieure à 50 ns, par exemple 10 ns.
- une énergie d'impulsion comprise entre 100 et 1500 mJ/cm2
- une fréquence de répétition des impulsions comprise ente 1 Hz, et 10 kHz.

**Premier mode de réalisation.**

Dans un premier mode de réalisation, illustré aux figures 3 et 4, il est question de réaliser un épaississement par épitaxie de la couche utile 2 d'une structure 1 constituée par un substrat de silicium sur isolant.

La couche d'isolant 3 est une couche de dioxyde de silicium de 25nm. La couche utile 2 est une couche de silicium de 12 nm en moyenne et présente une variation d'épaisseur s'étendant de 11,5 nm à 12,5 nm.

Une étape préliminaire de modélisation de la structure conduit à déterminer les sensibilités de la réflectivité de la structure 1 par rapport à la couche de silicium (courbe SOI1 sur la figure 6) et la couche de dioxyde de silicium (courbe BOX1 sur la figure 6), respectivement.

Le rectangle en pointillés apparaissant sur le graphe de la figure 6, indique une gamme de longueurs d'ondes appropriées pour un mode de chauffage A. Dans le cas de cet exemple, on choisit un laser de longueur d'onde de 510nm.

La structure 1 est donc installée de préférence sur un support de structure 5 dans une enceinte de réaction 9.

Des espèces chimiques 6 sous forme gazeuse sont introduites dans l'enceinte de réaction 9, les espèces chimiques 6 étant susceptibles de réagir chimiquement avec la couche utile 2, avec une cinétique strictement croissante en fonction de la température de la couche utile 2.

De manière particulièrement avantageuse, les espèces chimiques 6 introduites dans la chambre de réaction peuvent comprendre au moins une des espèces suivantes : Silane, di-silane, tri-silane, mono-chlorosilane, di-chlorosilane, tri-chlorosilane, tétra-chlorosilane, germane, mono-chlorogermane, di-chlorogermane, tri-chlorogermane, tétra-chlorogermane.

Les espèces chimiques 6 injectées dans la chambre de réaction sont généralement diluées dans un gaz porteur comprenant au moins un des gaz suivants : Azote, Argon, Dihydrogène.

La couche utile 2 est alors chauffée par un faisceau 8 laser à impulsions, le faisceau 8 balayant au moins en partie la surface libre S la couche utile 2.

Une fenêtre transparente au faisceau 8 laser à impulsions est ménagée dans l'enceinte, de sorte à permettre au faisceau 8 laser à impulsions, généré hors de l'enceinte réactive, de produire une échauffement de la couche utile 2 disposée à l'intérieur de l'enceinte réactive.

La surface libre S de la couche utile 2 est alors balayée par mouvements du faisceau 8 laser à impulsions et/ou par mouvement du support 5 sur lequel repose la structure 1.

Ainsi, lors de l'impact du faisceau 8 laser à impulsions sur la surface libre S de la couche utile 2, il se produit un échauffement de la couche utile 2 au niveau du point d'impact P.

Ainsi, lorsque le faisceau 8 laser à impulsions balaie la surface, il se produit un échauffement plus important dans les zones de la couche utile 2 les plus fines que dans les zones les plus épaisses, indépendamment des variations d'épaisseur de la couche d'isolant 3.

Cet échauffement provoque la réaction des espèces chimiques 6 avec la couche utile 2.

Dans le présent mode de réalisation, la réaction chimique est une réaction d'épaississement par épitaxie de la couche utile 2.

Les zones les plus fines de la couche utile 2 subissant un échauffement plus important que les zones épaisses, la réaction d'épaississement par épitaxie se déroule à une vitesse plus importante dans les zones fines que dans les zones épaisses.

Par conséquent, lors de l'épaississement de la couche utile 2, l'écart d'épaisseur entre les zones fines et les zones épaisses de la couche utile 2 diminue.

Ainsi, cette structure 1 est irradiée par un laser à impulsions d'une longueur d'onde de 510 nm, avec des impulsions de 10 ns, les impulsions étant répétées à une fréquence de 10 kHz, chaque impulsion ayant une énergie de 500 mJ/cm$^2$ permet de chauffer la couche silicium. Le temps de traitement étant de 10 secondes par zone irradiée. Le point d'impact du faisceau laser est de 10 mm$^2$.

Pendant l'irradiation, la structure 1 est dans une atmosphère d'espèces chimiques 6 comprenant un mélange de dichlorsilane et de dihydrogène, à une pression de 80 mT.

Un tel traitement exécuté sur toute la structure 1 permet de réduire la non uniformité en épaisseur à 0,2 nm par rapport à une non uniformité initiale de 1 nm. Cette non uniformité correspond à des variations d'épaisseur de la couche utile 2 de longueur d'onde spatiale supérieure au seuil I de 0,9 micromètre.

Par ailleurs, pour des impulsions de 10ns, il est possible de réduire des variations d'épaisseur de la couche utile 2 de longueur d'onde supérieure au seuil de l'ordre de 1micron, ce qui est bien plus faible que la dimension du point d'impact du faisceau.

**Second mode de réalisation.**

Dans un second mode de réalisation, il est question de réaliser un amincissement par gravure d'une couche utile 2.

Une structure 1, dont les courbes de sensibilités sont représentées sur la figure 9, est donc installée de préférence sur un support de structure 5 dans une enceinte de réaction 9.

Des espèces chimiques 6 sous forme gazeuse sont introduites dans l'enceinte de réaction 9, les espèces chimiques 6 étant susceptibles de réagir chimiquement pour graver la couche utile 2, avec une cinétique strictement croissante en fonction de la température de la couche utile 2.

De manière particulièrement avantageuse, les espèces chimiques 6 introduites dans la chambre de réaction comprennent au moins une des espèces suivantes : HCL.

Les espèces chimiques 6 injectées dans la chambre de réaction sont généralement diluées dans un gaz porteur comprenant au moins une des gaz suivants : Argon, Dihydrogène.

La couche utile 2 est alors chauffée par un faisceau 8 laser à impulsions, le faisceau 8 balayant au moins en partie la surface libre S la couche utile 2. Une fenêtre transparente au faisceau 8 laser à impulsions est ménagée dans l'enceinte, de sorte à permettre au faisceau 8 laser à impulsions généré hors de l'enceinte réactive de chauffer la couche utile 2 disposée à l'intérieur de l'enceinte réactive.

La surface libre S de la couche utile 2 est alors balayée par mouvement du faisceau 8 laser à impulsions et/ou par mouvement de la structure 1.

La longueur d'onde du faisceau 8 laser est choisie pour remplir les deux conditions d'un mode de chauffage B représenté sur la figure 9, par exemple sa longueur d'onde est choisie différente de moins de 15 nm, de préférence de moins de 7 nm, de la longueur d'onde centrale de 350 nm. Les autres paramètres du laser sont identiques à ceux choisis dans le premier mode de réalisation.

Ainsi, lors de l'impact du faisceau 8 laser à impulsions sur la surface libre S de la couche utile 2, il se produit un échauffement de la couche utile 2 au niveau du point d'impact.

Par ailleurs, lorsque le faisceau 8 laser à impulsions balaie la surface libre S de la couche utile 2, il se produit un échauffement plus important dans les zones de la couche utile 2 les plus épaisses que dans les zones les plus fines.

Cet échauffement provoque la réaction des espèces chimiques 6 avec la couche utile 2.

Dans le présent mode de réalisation, la réaction chimique est une réaction d'amincissement par gravure de la couche utile 2.

Les zones les plus épaisses de la couche utile 2 subissant un échauffement plus important que les zones les plus fines, la réaction d'amincissement par gravure se déroule à une vitesse plus importante dans les zones épaisses que dans les zones fines.

Par conséquent, lorsque la réaction d'amincissement par gravure de la couche utile 2 se déroule, l'écart d'épaisseur entre les zones fines et les zones épaisses de la couche utile 2 diminue.

Pendant l'irradiation, la structure 1 est dans une atmosphère d'espèces chimiques 6 comprenant un mélange d'acide chlorhydrique et de dihydrogène, à une pression comprise entre 2.67 Pa et $1*10^5$ Pa (20 mTorr et 760 Torr).

Un tel traitement exécuté sur toute la structure 1 permet de réduire la non uniformité en épaisseur par rapport à une non uniformité initiale de la couche utile 2. Cette non uniformité correspond à des variations d'épaisseur de la couche utile 2 de longueur d'onde spatiale supérieure au seuil l de 0,9 micromètre.

## Revendications

1. Procédé de traitement d'une structure (1), la structure (1) comprenant de sa face arrière vers sa face avant un substrat support (4), une couche d'isolant (3), et une couche utile (2), la couche utile (2) présentant une surface libre (S), la structure (1) étant placé dans une atmosphère comprenant des espèces chimiques (6) sous forme gazeuse, les espèces chimiques (6) étant susceptibles de réagir chimiquement avec la couche utile (2), avec une cinétique strictement croissante en fonction de la température de la couche utile (2); ledit procédé de traitement étant **caractérisé en ce que** la couche utile (2) est chauffée par un faisceau (8) laser à impulsions, le faisceau (8) balayant au moins en partie la surface libre (S) de la couche utile (2), la longueur d'onde du faisceau (8) étant différent de moins de 15 nm, de préférence de moins de 7 nm, d'une longueur d'onde centrale, pour laquelle la dérivée partielle de la réflectivité de la structure (1) par rapport à l'épaisseur de la couche d'isolant (3) est nulle.

2. Procédé de traitement selon la revendication 1, dans lequel la durée des impulsions du faisceau laser est inférieure à une valeur tv, tv étant égal à $l^2/D$, D étant le coefficient de diffusion thermique dans la couche utile 2, et l correspondant à une longueur d'onde seuil de traitement

3. Procédé de traitement selon la revendication 1, dans lequel le faisceau (8) laser à impulsions a une durée d'impulsion inférieure à 100 ns.

4. Procédé de traitement selon l'une des revendications 1 à 3, dans lequel la couche utile (2) est une couche de matériau semi-conducteur comprenant au moins un des matériaux suivant : Silicium, Germanium, Alliage de silicium Germanium.

5. Procédé de traitement selon l'une des revendications 1 à 4, dans lequel les espèces chimiques (6) permettent de graver la couche utile (2), la longueur d'onde du faisceau (8) laser à impulsions est choisie de sorte à correspondre à une valeur négative de la sensibilité de la réflectivité estimée de la structure (1) par rapport à la couche utile (2).

6. Procédé de traitement selon la revendication 5, dans lequel les espèces chimiques (6) comprennent du HCl.

7. Procédé de traitement selon l'une des revendications 1 à 4, dans lequel les espèces chimiques (6) permettent d'épaissir la couche utile (2) par épitaxie, et la longueur d'onde du faisceau (8) laser à impulsions est choisi de sorte à correspondre à une valeur positive de la sensibilité de la réflectivité estimée de la structure (1) par rapport à la couche utile (2).

8. Procédé de traitement selon la revendication 7, dans lequel les espèces chimiques (6) comprennent au moins une des espèces suivante : Silane, di-silane, tri-silane, mono-chlorosiliane, di-chlorosilane, tri-chlorosilane, tétra-chlorosilane, germane, mono-chlorogermane, di-chlorogermane, trichlorogermane, tétrachlorogermane.

9. Procédé de traitement selon l'une des revendications 1 à 8, dans lequel la couche d'isolant (3) comprend du dioxyde de silicium.

10. Procédé de traitement selon l'une des revendications 1 à 9, dans lequel la couche d'isolant (3) présente une épaisseur inférieure à 150 nm, de préférence inférieure à 50 nm, encore plus préférentiellement inférieure à 25 nm.

11. Procédé de traitement selon l'une des revendications 1 à 10, dans lequel la couche utile (2) présente une épaisseur inférieure à 50 nm, préférentiellement inférieur à 25 nm.

12. Procédé de traitement selon l'une des revendications 1 à 11, dans lequel la surface du point d'impact (P) du faisceau laser sur la surface libre (S) de la couche utile (2) est supérieure à 0.1 mm$^2$, de préférence supérieure à 10 mm$^2$.

13. Procédé de traitement selon l'une des revendications 1 à 12, dans lequel le faisceau (8) laser à impulsions a une énergie d'impulsion comprise entre 100 et 1500 mJ/cm2.

14. Procédé de traitement selon l'une des revendications 1 à 13, dans lequel le faisceau (8) laser à impulsions a une fréquence de répétition des impulsions comprise ente 1 Hz, et 10 kHz.

15. Procédé de traitement selon l'une des revendications 1 à 14, dans lequel la couche utile (2) présente une variation d'épaisseur inférieure à 3nm, de préférence inférieure à 2nm, encore plus préférentiellement inférieure à 1nm.

**Patentansprüche**

1. Verfahren zur Behandlung einer Struktur (1), wobei die Struktur (1) von ihrer Rückseite zur Vorderseite ein Trägersubstrat (4), eine isolierende Schicht (3) und eine Nutzschicht (2) umfasst, wobei die Nutzschicht (2) eine freie Fläche (S) aufweist, die Struktur (1) in eine Atmosphäre platziert ist, die chemische Spezies (6) in Gasform umfasst und die chemischen Spezies (6) chemisch mit der Nutzschicht (2) reagieren können, mit einer strengen, entsprechend der Temperatur der Nutzschicht (2) zunehmenden Kinetik, wobei besagtes Behandlungsverfahren **dadurch gekennzeichnet ist, dass** die Nutzschicht (2) durch einen Impulslaserstrahl (8) erhitzt wird, wobei der Strahl (8) mindestens einen Teil der freien Fläche (S) der Nutzschicht (2) abtastet, wobei die Wellenlänge des Strahls (8) weniger als 15 nm, vorzugsweise weniger als 7 nm, von einer Mittenwellenlänge abweicht, bei der die partielle Ableitung des Reflexionsvermögens der Struktur (1) in Bezug auf die Dicke der isolierenden Schicht (3) gleich Null ist.

2. Behandlungsverfahren nach Anspruch 1, bei dem die Dauer der Impulse des Laserstrahls kleiner als ein Wert tv ist, wobei tv gleich $l^2/D$ ist, wobei D die Temperaturleitzahl in der Nutzschicht 2 ist, und I einem Grenzwert der Behandlungswellenlänge entspricht.

3. Behandlungsverfahren nach Anspruch 1, in welchen der Laserstrahl (8) eine Impulsdauer unter 100 ns hat.

4. Behandlungsverfahren nach einem der Ansprüche 1 bis 3, in welchem die Nutzschicht (2) eine Schicht aus Halbleitermaterial ist, die mindestens eines der folgenden Materialien umfasst: Silizium, Germanium, Germanium-Silizium-Legierung.

5. Behandlungsverfahren nach einem der Ansprüche 1 bis 4, bei dem chemische Spezies (6) das Gravieren der Nutzschicht (2) ermöglichen, wobei die Wellenlänge des Impulslaserstrahls (8) so ausgewählt wird, dass sie einem negativen Wert der Empfindlichkeit des veranschlagten Reflexionsvermögens der Struktur (1) in Bezug auf die Nutzschicht (2) entspricht.

6. Behandlungsverfahren nach Anspruch 5, in dem die chemischen Spezies (6) HCl umfassen.

7. Behandlungsverfahren nach einem der Ansprüche 1 bis 4, in welchem die chemischen Spezies (6) das Verdicken der Nutzschicht (2) durch Epitaxie ermöglichen und die Wellenlänge des Impulslaserstrahls (8) so ausgewählt wird, dass sie einem positiven Wert der Empfindlichkeit des veranschlagten Reflexionsvermögens der Struktur (1) in Bezug auf die Nutzschicht (2) entspricht.

8. Behandlungsverfahren nach Anspruch 7, in welchem die chemische Spezies (6) mindestens eine der nachfolgenden Spezies umfassen: Silan, Disilan, Trisilan, Monochlorsilan, Dichlorsilan, Trichlorsilan, Tetrachlorsilan, German, Monochlorgerman, Dichlorgerman, Trichlorgermaan,, Tetrachlorgerman.

9. Behandlungsverfahren nach einem der Ansprüche 1 bis 8, in welchem die isolierende Schicht (3) Siliziumdioxid umfasst.

10. Behandlungsverfahren nach einem der Ansprüche 1 bis 9, in welchem die isolierende Schicht (3) eine Dicke kleiner 150 nm, vorzugsweise aber kleiner 50 nm und idealerweise kleiner 25 nm aufweist.

11. Behandlungsverfahren nach einem der Ansprüche 1 bis 10, in welchem die Nutzschicht (2) eine Dicke kleiner 50 nm, vorzugsweise aber kleiner 25 nm aufweist.

12. Behandlungsverfahren nach einem der Ansprüche 1 bis 11, in welchen die Fläche des Auftreffpunkts (P) des Laserstrahls auf der freien Fläche (S) der Nutzschicht (2) größer als 0.1 mm$^2$, vorzugsweise aber größer als 10 mm$^2$ ist.

13. Behandlungsverfahren nach einem der Ansprüche 1 bis 12, in welchem der Impulslaserstrahl (8) eine Impulsenergie zwischen 100 und 1500 mJ/cm$^2$ hat.

**14.** Behandlungsverfahren nach einem der Ansprüche 1 bis 13, in welchen der Impulslaserstrahl (8) eine Impulswiederholungsfrequenz von 1 Hz bis 10 kHz hat.

**15.** Behandlungsverfahren nach einem der Ansprüche 1 bis 14, bei dem sich die Dicke der Nutzschicht (2) weniger als 3nm, vorzugsweise weniger als 2nm in, und idealerweise weniger als 1 nm verändert.

**Claims**

**1.** A method for treating a structure (1), the structure (1) comprising, from the rear face thereof to the front face thereof, a supporting substrate (4), a layer of insulation (3) and a useful layer (2), the useful layer (2) having a free surface (S), the structure (1) being placed in an atmosphere comprising chemical species (6) in gaseous form, the chemical species (6) being liable to react chemically with the useful layer (2), with kinetics strictly increasing according to the temperature of the useful layer (2); said treatment method being **characterised in that** the useful layer (2) is heated by a pulsed laser beam (8), the beam (8) at least partly sweeping the free surface (S) of the useful layer (2), the wavelength of the beam (8) being different by at least 15 nm, preferably at least 7 nm, from a centre wavelength, for which the partial derivative of the reflectivity of the structure (1) with respect to the thickness of the layer of insulation (3) is zero.

**2.** The treatment method according to claim 1, wherein the duration of the pulses of the laser beam is less than a value tv, tv being equal to $l^2/D$, D being the coefficient of thermal diffusion in the useful layer 2 and l corresponding to a threshold treatment wavelength.

**3.** The treatment method according to claim 1, wherein the pulsed laser beam (8) has a pulse duration of less than 100 ns.

**4.** The treatment method according to any of claims 1 to 3, wherein the useful layer (2) is a layer of semiconductive material comprising at least one of the following materials: silicon, germanium or silicon germanium alloy.

**5.** The treatment method according to any of claims 1 to 4, wherein the chemical species (6) make it possible to etch the useful layer (2), the wavelength of the pulsed laser beam (8) being chosen so as to correspond to a negative value of the sensitivity of the estimated reflectivity of the structure (1) with respect to the useful layer (2).

**6.** The treatment method according to claim 5, wherein the chemical species (6) comprise HCl.

**7.** The treatment method according to any of claims 1 to 4, wherein the chemical species (6) make it possible to thicken the useful layer (2) by epitaxy, and the wavelength of the pulsed laser beam (8) is chosen so as to correspond to a positive value of the sensitivity of the estimated reflectivity of the structure (1) with respect to the useful layer (2).

**8.** The treatment method according to claim 7, wherein the chemical species (6) comprise at least one of the following species: silane, disilane, trisilane, mono-chlorosilane, dichlorosilane, trichlorosilane, tetra-chlorosilane, germanium, monochlorogermanium, dichlorogermanium, trichlorogermanium, tetrachlorogermanium.

**9.** The treatment method according to any of claims 1 to 8, wherein the layer of insulation (3) comprises silicon dioxide.

**10.** The treatment method according to any of claims 1 to 9, wherein the layer of insulation (3) has a thickness of less than 150 nm, preferably less than 50 nm, even more preferentially less than 25 nm.

**11.** The treatment method according to any of claims 1 to 10, wherein the useful layer (2) has a thickness of less than 50 nm, preferentially less than 25 nm.

**12.** The treatment method according to any of claims 1 to 11, wherein the surface area of the point of impact (P) of the laser beam on the free surface (S) of the useful layer (2) is greater than 0.1 $mm^2$, preferably greater than 10 $mm^2$.

**13.** The treatment method according to any of claims 1 to 12, wherein the pulsed laser beam (8) has a pulse energy of between 100 and 1500 mJ/$cm^2$.

**14.** The treatment method according to any of claims 1 to 13, wherein the pulsed laser beam (8) has a pulse-repetition frequency of between 1 Hz and 10 kHz.

**15.** The treatment method according to any of claims 1 to 14, wherein the useful layer (2) has a variation in thickness of less than 3 nm, preferably less than 2 nm, even more preferentially less than 1 nm.

**Fig 1 Art antérieur**

**Fig 2 Art antérieur**

**Fig 3**

**Fig 4**

**Fig 5**

**Fig 6**

**Fig 7**

**Fig 8**

**Fig 9**

# EP 2 962 326 B1

## RÉFÉRENCES CITÉES DANS LA DESCRIPTION

**Documents brevets cités dans la description**

- US 20090121157 A

**Littérature non-brevet citée dans la description**

- **H.G. TOMPKINS ; W.A MCGAHAN.** Spectroscopic Ellipsometry and reflectometry, a user guide. 1999

- **D.L WINDT.** IMD - Software for modeling the optical properties of multilayer films. *COMPUTER IN PHYSISCS,* Juillet 1998, vol. 12 (4